# EUROPEAN PATENT APPLICATION

(11) **EP 2 107 748 A1**
(43) Date of publication of application: **07.10.2009**
(21) Application number: 08706592.6
(22) Date of filing: 30.01.2008
(51) Int. Cl.: H04L 27/00

(54) **A CODING METHOD AND APPARATUS BASED ON THE REDUCED TRANSMISSION TIME INTERVAL (RTTI)**

(30) Priority: 30.01.2007 CN 200710002788
(71) Applicant: Huawei Technologies Co., Ltd., Shenzhen, Guangdong Province 518129 (CN)
(72) Inventor: LIU, Guang, Shenzhen Guangdong 518129 (CN); ZHOU, Liping, Shenzhen Guangdong 518129 (CN)
(74) Representative: Barth, Stephan Manuel
(86) International application number: PCT/CN2008/070215
(87) International publication number: WO 2008/092409

(57) **Abstract**

A coding method based on RTTI includes: acquiring an RTTI radio block; performing convolutional coding on the RTTI radio block; and swapping bits of the data after being convolutionally coded according to a preset swap rule. A coding apparatus includes: an acquiring unit, configured to acquire an RTTI control block and send the RTTI radio block to a convolutional coding unit; the convolutional coding unit, configured to convolutionally code the received RTTI control block; and a bit swap unit, configured to swap bits of the data after being convolutionally coded according to a preset swap rule. The present invention can effectively lower the impact of RTTI on the radio performance of channels.

## Description

### Field of the Invention

The present invention relates to communication technologies, and in particular, to a coding method and apparatus based on the reduced transmission time interval (RTTI).

### Background of the Invention

The general packet radio service (GPRS) network and third generation (3G) network may coexist for a long time, which requires the GPRS network to support 3G services and ensure the service continuity of 3G/GPRS subscribers when they move between the coverage areas of the GPRS and 3G systems. The 3G services mentioned herein include session services, for example, Voice over Internet Protocol (VoIP) services. VoIP services require a small end-to-end delay which is about 300 ms and a low frame error rate (FER) which is about 1%. A low FER may be achieved through multiple times of retransmission. Therefore, how to achieve a low delay is the major issue.

RTTI is a solution to reducing the delay by reducing the transmission time interval (TTI). It is the major method for reducing the delay at present.

For example, the TTI of a BTTI radio block, which is the time needed to transmit a radio block on one PDCH using a basic TTI configuration, is four TDMA frames, i.e. 20 ms. The basic principle of RTTI is to map the radio blocks that were previously mapped to one packet data channel (Packet Data Channel, PDCH) to two PDCHs. Therefore, the TTI of a RTTI radio block is reduced to 10 ms. In addition, the two PDCHs may use two different timeslots on the same carrier or the same timeslot on two different carriers (currently, the dual-carrier mode is supported in the downlink direction).

When the RTTI is supported in the downlink direction, the normal use of old version mobile stations (MSs) should be supported on corresponding uplink channels. Therefore, the scheduling mechanism of the downlink channels cannot be changed to ensure the compatibility with old MSs. The scheduling of uplink resources depends on uplink state flags (USFs). Each USF has 3 bits and can indicate up to 8 values. The basic principles of USF scheduling are as follows:

1. During uplink channel assignment, each uplink channel is assigned a USF. The USFs assigned to different MSs on the same channel cannot be the same. That is, an uplink channel can be used by eight MSs at most.

2. The assignment of an uplink channel does not mean an MS can use the assigned channel all the time. Instead, the uplink channel can be used only after being scheduled by the network.

3. An MS assigned an uplink channel can receive the USF carried in the radio block from the corresponding downlink channel. After receiving the proper USF, the MS can send an uplink data packet in the next radio block on the uplink channel. The MS keeps waiting and cannot send any data before it receives the proper USF from the downlink channel.

Therefore, the major RTTI problem is to ensure that the downlink data can be sent in RTTI mode and that old MSs can receive USFs correctly on the downlink channels.

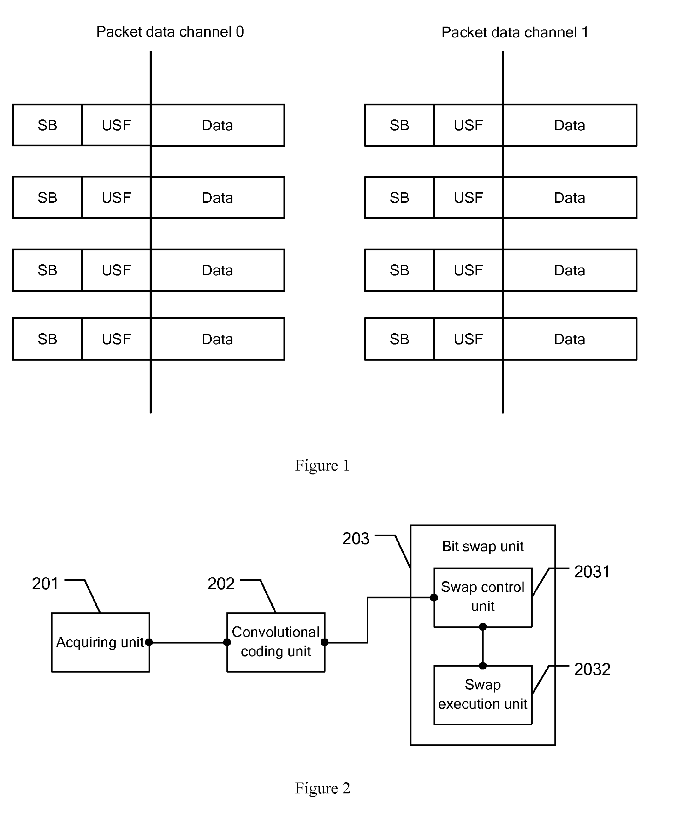

A coding scheme in the prior art is as follows: there is a one-to-one relationship between the placement formats and the coding formats of USFs. Therefore, before the USFs are acquired, the stealing bits (SB) should be read to indicate the four coding formats, namely, coding scheme-1 (CS-1), CS-2, CS-3, and CS-4. After RTTI is introduced, to ensure that old MSs can use the uplink channels, the placement of the SB and USF should be the same as that before RTTI is introduced, that is, when the downlink data blocks are placed in RTTI mode, the SB and USF are still placed in the original TTI mode (see Figure 1).

After RTTI is introduced, however, the SB and USF can be coded in the CS-4 format and placed at the TTI of 20 ms, while the data is coded according to a modulation and coding scheme (MCS-1/2/3/4) and placed according to RTTI. Therefore, the position where the USF is to be placed may have been occupied by data, which causes errors in data block transmission and affects the radio performance of channels.

### Summary of the Invention

Various embodiments of the present invention provide a coding method and apparatus based on RTTI to reduce the negative impact of RTTI on the radio performance of channels.

A coding method based on RTTI includes: acquiring an RTTI radio block; performing convolutional coding on the RTTI radio block; and swapping bits of the data after being convolutionally coded according to a preset swap rule.

A coding apparatus includes: an acquiring unit, a convolutional coding unit, and a bit swap unit. The acquiring unit is configured to acquire an RTTI radio block and send the RTTI radio block to the convolutional coding unit. The convolutional coding unit is configured to convolutionally code the received RTTI radio block. The bit swap unit is configured to swap bits of the data after being convolutionally coded according to a preset swap rule.

According to the technical solution provided in the embodiments of the present invention, the bits of the convolutionally-coded data can be swapped in multiple modes. For example, swap of the less important bits can reduce the probability of replacing or deleting important data when a USF is placed, lower the data error rate, and lower the bad impact of RTTI on the radio performance of channels.

### Brief Description of the Drawings

Figure 1 illustrates the mode for placing the USF, SB, and data in RTTI mode according to the prior art;

Figure 2 is a schematic diagram of the coding apparatus according to an embodiment of the present invention;

Figure 3 is a flowchart of the coding method according to an embodiment of the present invention;

Figure 4 illustrates the pre-placement positions of the USFs according to an embodiment of the present invention;

Figure 5 is a schematic diagram of the first MSC-1/2/3/4 scheme for RTTI data blocks according to an embodiment of the present invention;

Figure 6 is a schematic diagram of the second CS-1 scheme for RTTI control blocks according to an embodiment of the present invention; and

Figure 7 is a schematic diagram of the second MSC-1/2/3/4 scheme for RTTI data blocks according to an embodiment of the present invention.

### Detailed Description of the Invention

Various embodiments of the present invention provide a coding method and apparatus based on RTTI to lower the negative impact of RTTI on the radio performance of channels.

The following describes the coding apparatus provided in an embodiment of the present invention. As shown in Figure 2, the coding apparatus includes: an acquiring unit 201, a convolutional coding unit 202, and a bit swap unit 203. The acquiring unit 201 is configured to acquire an RTTI radio block and send the RTTI radio block to the convolutional coding unit 202. The convolutional coding unit 202 is configured to convolutionally code the received RTTI radio block. The bit swap unit 203 is configured to swap bits of the data after being convolutionally coded according to a preset swap rule.

The bit swap unit 203 further includes: a swap control unit 2031 and a swap execution unit 2032. The swap control unit 2031 is configured to determine the positions of the bits to be swapped and send the position information to the swap execution unit 2032. The swap execution unit 2032 is configured to swap the bits according to the position information.

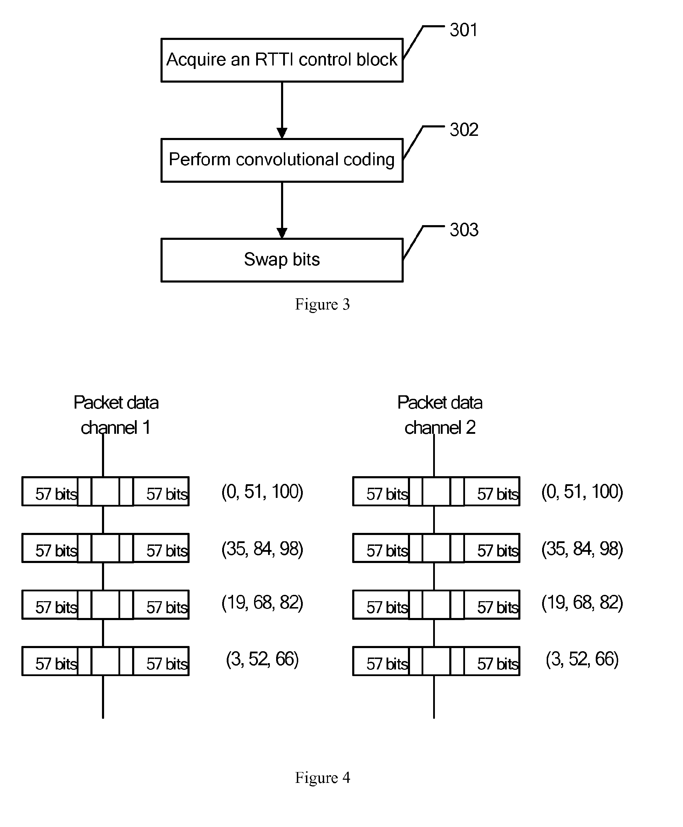

The coding method based on RTTI is hereinafter described in detail with reference to the coding apparatus provided in the embodiments. As shown in Figure 2 and Figure 3, the process of coding includes:

Step 301: The acquiring unit 201 acquires an RTTI radio block.

Step 302: The convolutional coding unit 202 convolutionally codes the RTTI radio block.

Step 303: The bit swap unit 203 swaps bits of the data after being convolutionally coded according to a preset swap rule.

As the person skilled in this field knows, the data after being convolutionally-coded also implicitly include the data interleaved after convolutional coding.

Based on whether the channel multiplexing information is acquired by the MS, the coding method can be classified into the following two types:

1. The MS acquires the channel multiplexing information:

In this condition, because the coding schemes depend on whether channels are multiplexed, the MS should acquire the channel multiplexing information first. Specifically, the MS is notified of the channel multiplexing information during the downlink channel assignment. If multiple channels are assigned, the MS should be notified of the multiplexing information of each channel.

Further, depending on whether bit swap is needed, this coding scheme can be classified into the following types:

A. Bit swap is needed:

Provided that the RTTI radio blocks are placed in the positions of the RTTI data blocks, as shown in Figure 4, when the USFs are placed in CS-4 mode at the TTI of 20 ms, they are placed in the positions indicated by the numerals in brackets. The 114 bits (namely, two 57 bits) of each burst are numbered 0, 1, ..., and 113. The USFs for CS-4 are placed in the marked positions. If an RTTI data block is placed in the first 10 ms of the 20 ms, the bits 0, 51, and 100 of the first two bursts and the bits 35, 84, and 98 of the next two bursts (namely, a total of 12 bits) are used to place USFs, and the original data in these bits should be deleted. According to the positions of bursts, the bits in the corresponding coding schemes can be acquired. According to different burst burst sequences, the bits may be different after convolutional coding.

In the first 10 ms of an RTTI radio block, bits 0, 51, and 100 of the first data burst, bits 35, 84, and 98 of the second data burst, bits 0, 51, and 100 of the third data burst, and bits 35, 84, and 98 of the fourth data burst are deleted. The convolutionally-coded bits in these positions are C(0), C(1), C(4), C(5), C(8), C(9), C(114), C(115), C(118), C(119), C(122), and C(123).

In the latter 10 ms, bits 19, 68, and 82 of the first data burst, bits 3, 52, and 66 of the second data burst, bits 19, 68, and 82 of the third data burst, and bits 3, 52, and 66 of the fourth data burst are deleted. The convolutionally-coded bits in these positions are C(2), C(3), C(6), C(7), C(10), C(11), C(344), C(345), C(348), C(349), C(352), and C(353).

Therefore, the preceding bits should be swapped in the case of bit swap.
For MCS-1/2/3/4:

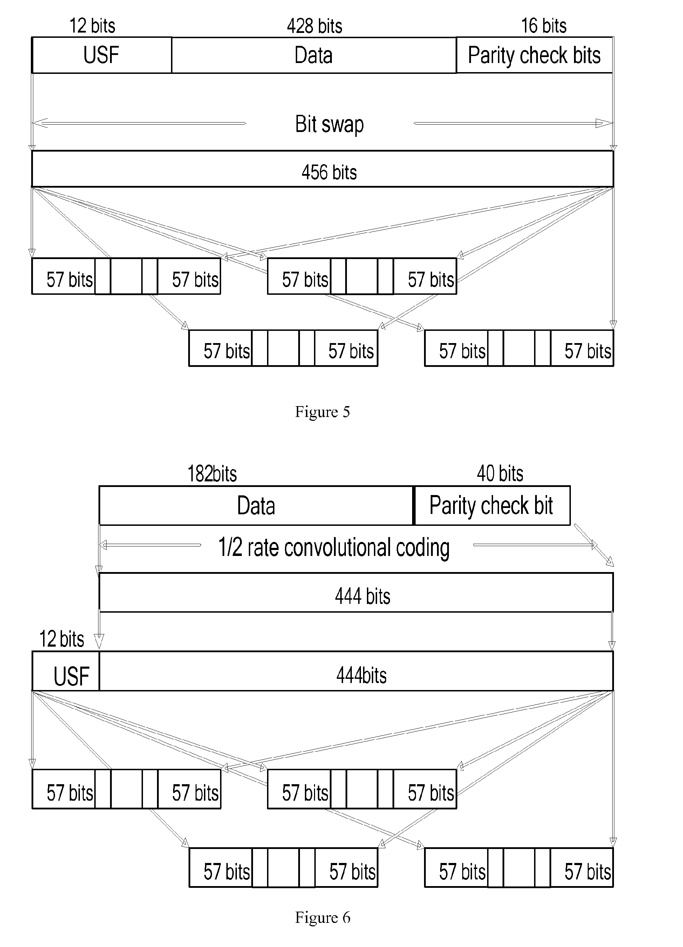

Figure 5 shows the coding method according a second embodiment of the present invention. The process of bit swap is as follows:

In the first 10 ms, the bits corresponding to C(2), C(3), C(6), C(7), C(10), and C(11) are swapped with the bits corresponding to C(114), C(115), C(118), C(119), C(122), and C(123).

In the latter 10 ms, the bits corresponding to C(0), C(1), C(4), C(5), C(8), and C(9) are swapped with the bits corresponding to C(344), C(345), C(348), C(349), C(352), and C(353).

B. Bit swap is not needed:

The objective of the present invention may also be realized without bit swap. Figure 6 shows the coding method according to a third embodiment of the present invention. It is in fact a new CS-1 format of the RTTI control block, that is, only the data part and parity bits are convolutionally coded (without regard to the original 3-bit USF and Tail), the data part is extended from 181 bits to 182 bits, and the parity bits remain unchanged.

After the convolutional coding is complete, the 12-bit USF and the 444-bit data acquired are combined into a complete 456-bit data block.

2. The MS does not acquire the channel multiplexing information:

In the foregoing technical solution, the multiplexing status of each channel needs be indicated in a downlink channel assignment message because the coding schemes depend on whether channels are multiplexed, and the MS needs be notified of the channel multiplexing status. The coding method may also be implemented while the channel multiplexing status is not indicated during the channel assignment. To achieve this objective, the coding scheme of RTTI radio blocks keeps the same irrespective of whether channels are multiplexed; otherwise, the MS cannot decode the radio blocks correctly.

(1). The control blocks coded in RTTI CS-1 mode can be coded according to the coding method provided in the first or third embodiment of the present invention.

(2). The data blocks coded in RTTI MCS-1/2/3/4 mode can be coded according to the coding method provided in the second embodiment of the present invention. That is, whether channels are multiplexed (20ms USFs are used) or not (10ms USFs are used), the SBs and USFs in RTTI MCS-1/2/3/4 mode are placed in the same positions as the SBs and USFs in 20ms CS-4 mode.

The improvements of the RTTI MCS-1/2/3/4 schemes are similar to but simpler than those of the CS-1 scheme. The bit swap is needed in a smaller scope, and only the positions of USFs are changed. The placement of the SBs and USFs in MCS-1/2/3/4 mode is the same as that in CS-4 mode. According to the positions of the bursts in RTTI radio blocks, the USFs in RTTI MCS-1/2/3/4 mode before bit swap are swapped with the corresponding bits in the bursts of the USFs in the original 20ms CS-4 mode.

According to the positions of bursts, the bits in the corresponding coding scheme can be acquired. According to different burst burst sequences, the bits may be different after convolutional coding.

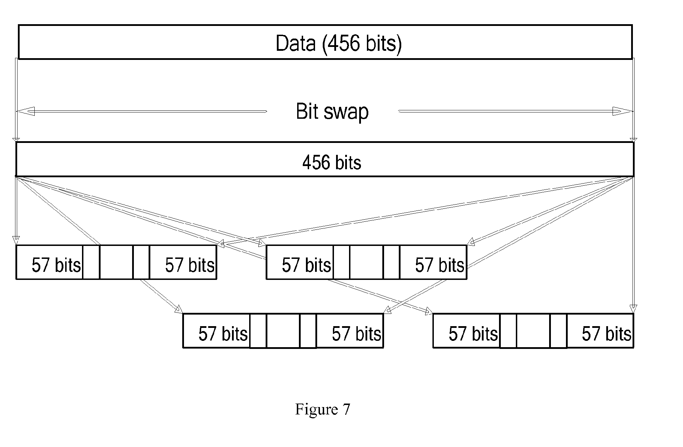

The following takes MCS-1/2/3/4 as an example for description. It is understandable that other coding formats are similar to MCS-1/2/3/4. Figure 7 shows the coding method according to a fourth embodiment of the present invention. The process of bit swap is as follows:

In the first 10 ms, the bits corresponding to C(2), C(3), C(6), C(7), C(10), and C(11) are swapped with the bits corresponding to C(114), C(115), C(118), C(119), C(122), and C(123).

In the latter 10 ms, the bits corresponding to C(0), C(1), C(4), C(5), C(8), and C(9) are swapped with the bits corresponding to C(344), C(345), C(348), C(349), C(352), and C(353).

Although the present invention has been described through some exemplary embodiments, the invention is not limited to such embodiments. It is apparent that those skilled in the art can make various modifications and variations to the invention without departing from the scope of the invention. The invention is intended to cover the modifications and variations provided that they fall in the scope of protection defined by the following claims or their equivalents.

## Claims

1. A coding method based on reduced transmission time interval, RTTI, comprising:
acquiring an RTTI radio block;
performing convolutional coding on the RTTI radio block; and
swapping bits of the data after being convolutionally coded according to a preset swap rule.

2. The method of claim 1, wherein swapping bits of the data after being convolutionally coded comprises:
among the data after being convolutionally coded, swapping the bits where uplink state flags, USF, should be mapped on a burst of a BTTI radio block in a basic radio block period, with those bits where USF should be mapped on the burst of a RTTI radio block in the basic radio block period.

3. The method of claim 2, wherein swapping bits is conducted among bits in the each burst.

4. The method of claim 1 or 2, before swapping bits of the data after being convolutionally coded, further comprising:
informing, by a network, channel multiplexing information to a mobile station; or
not informing, by a network, channel multiplexing information to a mobile station.

5. The method of claim 2, wherein:
the coding scheme of the RTTI radio block comprises MCS-1/2/3/4; and
the coding scheme of the BTTI radio block comprises CS-4.

6. The method of any one of claims 1, 2, and 3, wherein the data after being convolutionally coded comprises the data after being convolutionally coded and interleaved.

7. A coding apparatus, comprising: an acquiring unit (201), a convolutional coding unit (202), and a bit swap unit (203), wherein:
the acquiring unit (201) is configured to acquire a reduced transmission time interval, RTTI, radio block and send the RTTI radio block to the convolutional coding unit (202);
the convolutional coding unit (202) is configured to convolutionally code the received RTTI radio block; and
the bit swap unit (203) is configured to swap bits of the data after being convolutionally coded according to a preset swap rule.

8. The coding apparatus of claim 7, wherein the bit swap unit (203) comprises: a swap control unit (2031) and a swap execution unit (2032), wherein:
the swap control unit (2031) is configured to determine the positions of the bits to be swapped and send the position information to the swap execution unit (2032); and
the swap execution unit (2032) is configured to swap the bits according to the position information.
